# EUROPEAN PATENT SPECIFICATION

(11) **EP 4 660 643 B1**
(45) Date of publication and mention of the grant of the patent: **21.10.2026**
(21) Application number: 25177320.6
(22) Date of filing: 19.05.2025
(51) Int. Cl.: G01R 31/3185

(54) **TEST PATTERN RESET CONTROL CIRCUIT**
STEUERSCHALTUNG ZUM RÜCKSETZEN EINES TESTMUSTERS
CIRCUIT DE COMMANDE DE REMISE À ZÉRO DE MOTIF DE TEST

(30) Priority: 06.06.2024 US 202418735599
(43) Date of publication of application: 10.12.2025
(73) Proprietor: STMicroelectronics International N.V., 1228 Plan-les-Ouates, Geneva (CH)
(72) Inventor: KUMAR, Harish, 201301 Noida (IN); KUMAR, Nitin, 201310 Greater Noida (IN)
(74) Representative: Buzzi, Notaro & Antonielli d'Oulx S.p.A.

(56) References cited:
- EP-A1- 3 367 114
- US-A1- 2004 153 926
- US-A1- 2023 160 958
- US-A1- 20240 094 284

## Description

### TECHNICAL FIELD

The present description relates generally to testing of integrated circuits. One or more embodiments relate to circuits and structures for covering faults on the reset network of an integrated circuit and methods of operation thereof.

### BACKGROUND

As electronic devices become more and more complicated, hardware validation during manufacturing becomes increasingly important. Design for test (DFT) techniques are typically used to incorporate testability features into hardware design to improve testing capabilities. For example, a test controller, test registers, logic, and other components may be included in circuit design so that the circuit can be effectively tested. DFT is commonly used in conjunction with automatic test pattern generation (ATPG) to test for defective digital circuits in an automated fashion.

A test controller may be used to provide an interface between a general purpose computing device and a device under test (DUT) control. Test controllers may be external or integrated into the DUT. Industry standards such as the joint test action group (JTAG) standardize on-chip instrumentation for testing by specifying a serial communication interface that affords access to test registers.

US 2023/160958 A1 describes a reset control unit for a 3D stacked IC.

### SUMMARY

The invention is set out in the appended set of claims.

In accordance with an embodiment of the invention, a scan reset control circuit includes a single scan reset input configured to receive a reset signal, a plurality of scan reset outputs configured to be coupled to a plurality of circuit blocks in a one-to-one ratio, a plurality of writable non-scan test data registers including register outputs configured to assert or deassert the reset signal, and a plurality of reset enable circuits coupled to the plurality of scan reset outputs in a one-to-one ratio. Each of the scan reset outputs is configured to simultaneously reset a set of scan flip-flops of the corresponding circuit block. Each of the plurality of reset enable circuits includes an input coupled to the single scan reset input, a selector input coupled to the register outputs, and an output coupled to the corresponding scan reset output.

In accordance with another embodiment of the invention, an integrated circuit includes scan reset pad configured to receive a reset signal external to the integrated circuit, a plurality of circuit blocks including a set of scan flip-flops configured to be simultaneously reset by the reset signal, a plurality of writable non-scan test data registers including register outputs configured to assert or de-assert the reset signal, and a plurality of reset enable circuits coupled to the plurality of circuit blocks in a one-to-one ratio. Each of the plurality of reset enable circuits includes an input coupled to the scan reset pad, a selector input coupled to the register outputs, and an output coupled to the corresponding circuit block.

In accordance with still another embodiment of the invention, a method of testing an integrated circuit that includes a plurality of circuit blocks includes shifting a first test pattern into a plurality of sets of scan flip-flops of the integrated circuit, storing a first reset pattern in a plurality of writable non-scan test data registers of the integrated circuit, and asserting a scan reset signal at a scan reset pad of the integrated circuit to test for reset faults, deasserting the scan reset signal to a first subset of circuit blocks of the plurality of circuit blocks and asserting the scan reset signal to the remaining circuit blocks not in the first subset at outputs of the writable non-scan test data registers using the first reset pattern, launching the first test pattern while the scan reset signal is deasserted to the first subset of circuit blocks and asserted to the remaining circuit blocks not in the first subset, and capturing results of the first test pattern. Each set of scan flip-flops is included within a corresponding circuit block of the plurality of circuit blocks in a one-to-one ratio.

### BRIEF DESCRIPTION OF THE DRAWINGS

For a more complete understanding of the present invention, and the advantages thereof, reference is now made to the following descriptions taken in conjunction with the accompanying drawings, in which:
FIG. 1 illustrates an example scan reset control circuit configured to receive a scan reset signal and generate circuit block-specific reset signals using multiple writable non-scan test data registers and reset enable circuits in accordance with embodiments of the invention;
FIG. 2 illustrates an example integrated circuit that includes a scan reset control circuit configured to receive an external scan reset signal from a scan reset pad and generate circuit block-specific reset signals to a plurality of corresponding circuit blocks of the integrated circuit in accordance with embodiments of the invention;
FIG. 3 illustrates an example reset enable circuit that is usable in a scan reset control circuit and includes a scan reset multiplexer in accordance with embodiments of the invention;
FIG. 4 illustrates another example reset enable circuit that is usable in a scan reset control circuit and includes a scan enable multiplexer in addition to a scan reset multiplexer in accordance with embodiments of the invention;
FIG. 5 illustrates another example scan reset control circuit that includes a single register input coupled to a first register of a chain of writable non-scan test data registers configured in accordance with embodiments of the invention;
FIG. 6 illustrates still another example scan reset control circuit that includes multiple register inputs coupled to writable non-scan test data registers in a one-to-one ratio in accordance with embodiments of the invention;
FIG. 7 illustrates yet another example scan reset control circuit that includes a decoder coupled between writable non-scan test data registers and reset enable circuits where the total number of the test data registers is less than the total number of the reset enable circuits in accordance with embodiments of the invention;
FIG. 8 illustrates an example integrated circuit that includes a scan reset control circuit in top system-on-chip logic of the integrated circuit as well as six circuit blocks of different relative size and location in accordance with embodiments of the invention; and
FIG. 9 illustrates an example method of testing an integrated circuit in accordance with embodiments of the invention.

Corresponding numerals and symbols in the different figures generally refer to corresponding parts unless otherwise indicated. The figures are drawn to clearly illustrate the relevant aspects of the embodiments and are not necessarily drawn to scale. The edges of features drawn in the figures do not necessarily indicate the termination of the extent of the feature.

### DETAILED DESCRIPTION OF ILLUSTRATIVE EMBODIMENTS

The making and using of various embodiments are discussed in detail below. It should be appreciated, however, that the various embodiments described herein are applicable in a wide variety of specific contexts. The specific embodiments discussed are merely illustrative of specific ways to make and use various embodiments, and should not be construed in a limited scope. Unless specified otherwise, the expressions "around", "approximately", and "substantially" signify within 10%, and preferably within 5% of the given value or, such as in the case of substantially zero, less than 10% and preferably less than 5% of a comparable quantity.

Automatic test pattern generation (ATPG) patterns may be generated to cover as many types of faults as possible in a given integrated circuit. For example, it can be important to cover faults on the reset network of the integrated circuit with ATPG patterns. Conventional approaches pulse a reset signal to all the flip-flops in a design at the same time. However, as design sizes increase, the number of flip-flops that are being toggled simultaneously increases drastically. For example, it is not unheard of for modern design to include millions or even tens of millions of flip-flops that are simultaneously toggled.

Each flip-flop that is toggled causes current to flow in the design which results in a small drop in voltage (often referred to as IR drop in integrated circuit design from the ubiquitous equation V = IR). When large numbers of flip-flops are toggled simultaneously, a large amount of current flows and the corresponding IR drop is also large. This can cause the voltage inside the device to go below the working voltage of circuits included in the design, such as phase-locked loop (PLL) circuits, for example. In the specific example of PLL circuits, an IR drop below the working voltage can unlock the PLL circuit resulting in an unknown clock during the ATPG pattern. This may in turn lead to pattern failure or instabilities on silicon. Of course, undesirably low voltages due to IR drop can adversely affect any circuit or component causing instability and unpredictability. Therefore, excessive IR drop during testing of the integrated circuit is undesirable.

In accordance with embodiment herein described, the invention proposes to add a scan reset control circuit between a scan reset pad and the multiple circuit blocks of an integrated circuit. The scan reset control circuit allows the reset signal to desired circuit blocks to be switched off when pulsing the reset signal to avoid undesirable IR drop during testing. In various embodiments, the scan rest control circuit is configured to receive a reset signal at a single scan reset input and assert of deassert the reset signal at a plurality of scan reset outputs coupled to the circuit blocks in a one-to-one ratio. That is, a circuit block-specific reset signal configured to simultaneously reset a set of scan flip-flops of the corresponding circuit block is generated at each of the scan reset outputs.

The scan reset control circuit includes a plurality of writable non-scan test data registers, each comprising an output configured to assert of deassert the reset signal. The register outputs are coupled to a selector input of a plurality of reset enable circuits. Outputs of the reset enable circuits are coupled to the scan reset outputs in a one-to-one ratio. Specifically, the data stored in the test data registers may be considered a reset pattern that is used (either directly or indirectly, such as using an intervening decoder) to determine which circuit blocks receive the reset signal and which do not. The reset pattern may be updated after capturing test results to test circuit blocks that were not reset during a previous test.

Embodiments of the invention may have various advantages over conventional techniques. For example, the scan reset control circuits may allow desired circuit blocks to be switched off according to the specific needs of a given design to optimize mitigation of undesirable IR drop during patterns covering the reset network of an integrated circuit. The scan reset control circuit may be designed to have maximum flexibility by allowing the rest signal to any circuit block to be individually deasserted or a predetermined arrangement and number of circuit block combinations may be included which may advantageously require fewer circuit components, reduced complexity, and/or reduce the space required by the scan reset control circuit.

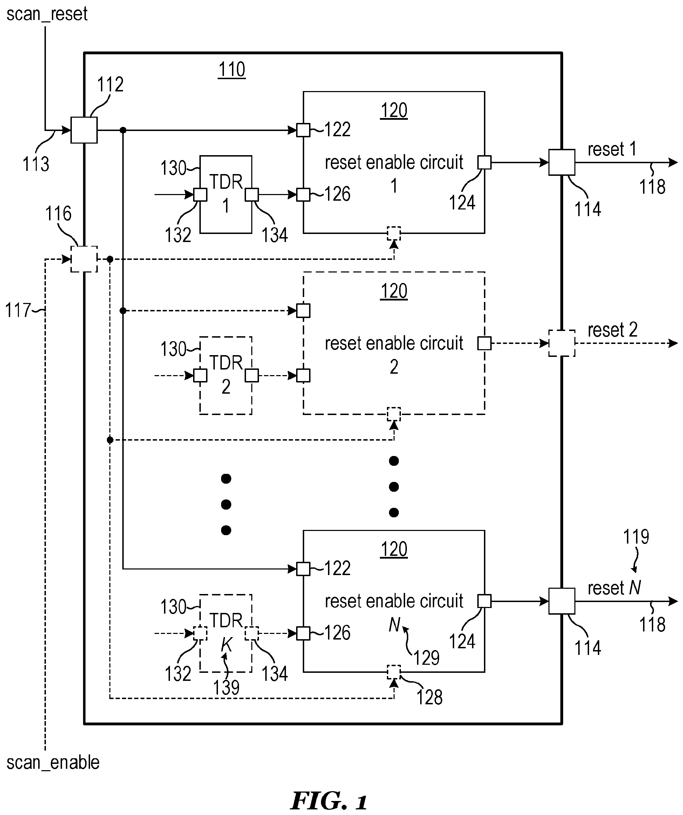

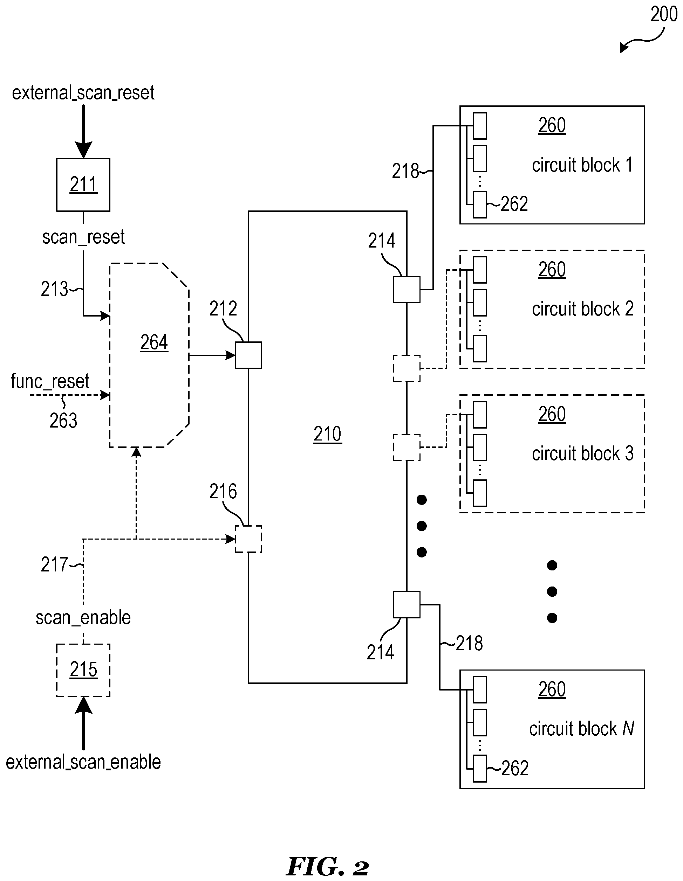

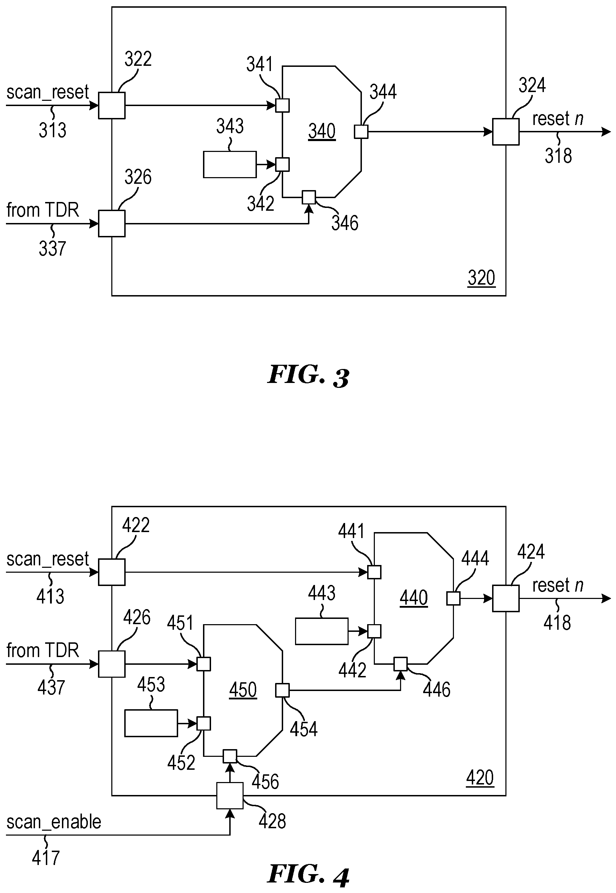

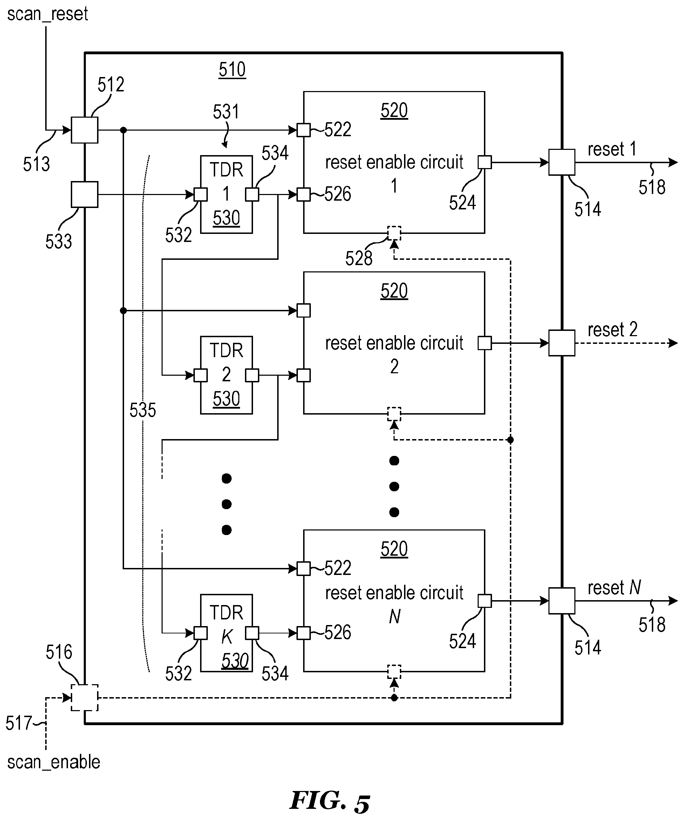

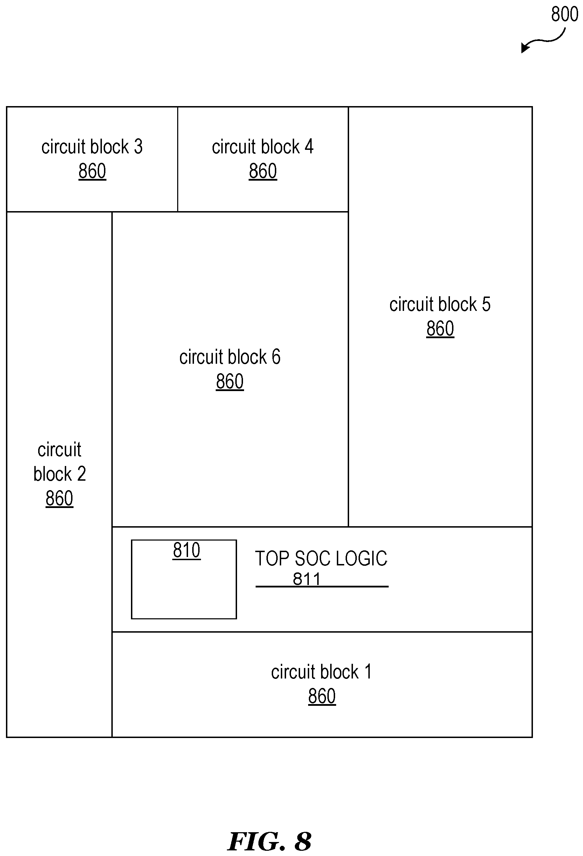

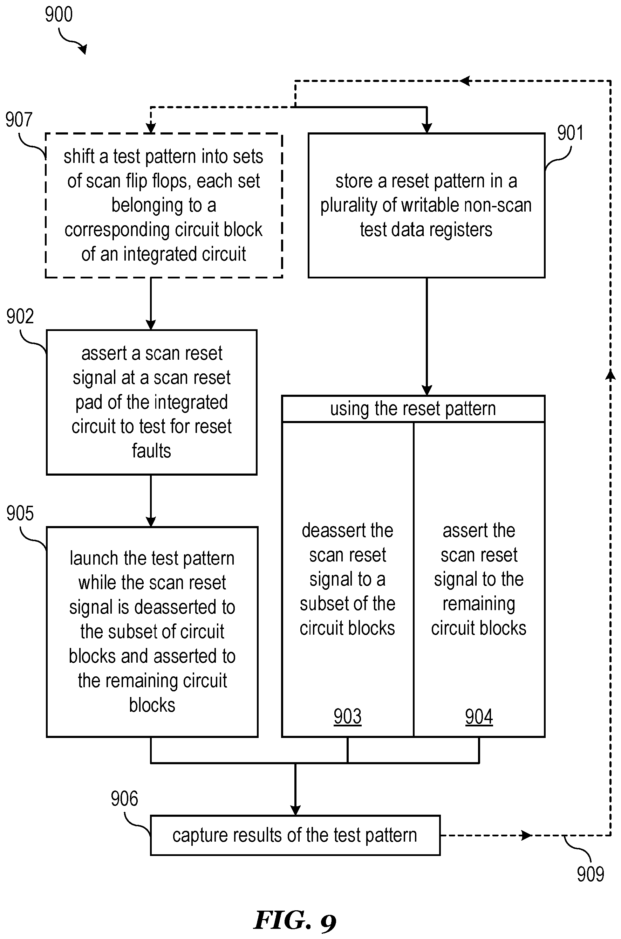

Embodiments provided below describe various circuits and structures for covering faults on the reset network of an integrated circuit that includes multiple circuit blocks, and, in particular embodiments, to scan reset control circuits that are configured to receive a scan reset signal and generate circuit block-specific reset signals using multiple writable non-scan test data registers and reset enable circuits. The following description describes the embodiments. FIG. 1 is used to describe an example scan reset control circuit. An example integrated circuit including a scan reset control circuit coupled to multiple circuit blocks is described using FIG. 2. FIGS. 3 and 4 are used to describe two exemplary reset enable circuits. Three more example scan reset control circuits are described using FIGS. 5-7. Another example integrated circuit is described using FIG. 8 while FIG. 9 is used to describe an example method of testing an integrated circuit.

FIG. 1 illustrates an example scan reset control circuit configured to receive a scan reset signal and generate circuit block-specific reset signals using multiple writable non-scan test data registers and reset enable circuits in accordance with embodiments of the invention.

Referring to FIG. 1, a scan reset control circuit 110 includes a single scan reset input 112 and a plurality of reset enable circuits 120, each coupled to a respective scan reset output 114. The single scan reset input 112 is configured to receive a reset signal 113, scan_reset that is provided to a reset enable circuit input 122 of each of the reset enable circuits 120 in a set of reset enable circuits. At least one test data register, TDR 130 is configured to control the assertion or deassertion of the reset signal 113 at each scan reset output 114 using a reset pattern that is stored using a corresponding register input 132 of each test data register 130 in a set of data registers. The respective bits of the reset pattern are then provided at register outputs 134 of the at least one test data register 130 coupled to reset enable circuit selector inputs 126 of the reset enable circuits 120.

The scan reset control circuit 110 includes at least two reset enable circuits 120 (each coupled to a corresponding scan reset output 114). However, any desired total number of reset enable circuits 129 (*N*) and corresponding total number of scan reset outputs 119 may be included to match the number of circuit blocks of an integrated circuit that includes the scan reset control circuit 110, for example. Each of the reset enable circuits 120 generates a circuit block-specific reset signal 118 at a reset enable circuit output 124. Each of the reset enable circuits 120 may include various circuit components (i.e., hardware logic components), such as inverters and logic gates, which may be together configured as various logic circuits, such as multiplexers, demultiplexers, etc. Of course, the specific implementation of the at least two reset enable circuits 120 may depend on the specific details of a given application.

While more than one test data register 130 is included in various embodiments, only one test data register 130 could be included, such as to toggle between two circuit blocks or two different sets of circuit blocks. That is, the total number of register outputs 139 (K) may be greater than or equal to one. In one example, the total number of register outputs 139 is equal to the total number of scan reset outputs 119 *(K = N*)*.* In other embodiments, the total number of register outputs 139 is less than the total number of scan reset outputs 119 *(K < N*), such as if a decoder is included between the at least one test data register 130 and the reset enable circuit selector inputs 126.

The at least one test data register 130 is a non-scan test data register (e.g., a user data register). For example, each included test data register 130 may be a JTAG writable register and may be accessed during a test process. Multiple reset patterns may be loaded into (i.e., stored in) the at least one test data register 130 in order to achieve full test coverage since one or more circuit blocks may be disabled for each test. The method by which the reset patterns are stored in the at least one test data register 130 may vary (e.g., from shifting the reset pattern into a chain of registers using a single register input into the scan reset control circuit 110 to storing the reset pattern in parallel through a plurality of register inputs coupled to the at least one test data register 130 in a one-to-one ratio and everything in between).

In some examples, the scan reset control circuit 110 also includes an optional scan enable input 516 configured to receive a scan enable signal 517 that is provided to a respective optional circuit enable input 128 of the reset enable circuits 120. For example, this may extend the functionality of the scan reset control circuit 110 to allow the reset signal 113 to be pass through the scan reset control circuit 110 undisturbed when the optional scan enable signal 517 is deasserted.

FIG. 2 illustrates an example integrated circuit that includes a scan reset control circuit configured to receive an external scan reset signal from a scan reset pad and generate circuit block-specific reset signals to a plurality of corresponding circuit blocks of the integrated circuit in accordance with embodiments of the invention. The integrated circuit of FIG. 2 may include any of the scan reset control circuits described herein such as the scan reset control circuit of FIG. 1, for example. Similarly labeled elements may be as previously described so that a corresponding description is not repeated for the sake of brevity.

Referring to FIG. 2, an integrated circuit 200 includes a scan reset control circuit 210 and at least two circuit blocks 260, each coupled to a respective scan reset output 214 of the scan reset control circuit 210. It should be noted that here and in the following a convention has been adopted for brevity and clarity wherein elements adhering to the pattern [x10] where 'x' is the figure number may be related implementations of a scan reset control circuit in various embodiments. For example, the scan reset control circuit 210 may be similar to the scan reset control circuit 110 except as otherwise stated. An analogous convention has also been adopted for other elements as made clear by the use of similar terms in conjunction with the aforementioned numbering system.

Each of the at least two circuit blocks 260 is configured to receive a circuit block-specific reset signal 218 that is generated by the scan reset control circuit 210. Each circuit block-specific reset signal 218 is configured to simultaneously reset a set of scan flip flops 262 included in corresponding circuit block. It should be noted that the circuit blocks 260 may be physical or logical. That is, while in many cases each of the circuit blocks 260 include a set of scan flip-flops located within a physically contiguous (often rectangular) area of the integrated circuit 200, this is not a requirement. In some cases one or more of the circuit block 260 may be defined as such merely by the fact that a respective circuit block-specific reset signal 218 is coupled to all of a particular set of scan flip-flops.

The integrated circuit 200 includes a scan reset pad 211 configured to be coupled to an external scan reset signal 213. The reset signal 213 is received by the scan reset control circuit 210 at a single scan reset input 212 and used in combination with a reset pattern to output a circuit block-specific reset signal 218 at each scan reset output 214.

Optionally, an optional scan enable pad 215 may be included that is configured to be coupled to an external scan enable signal 217 (i.e., a signal dictating whether scan mode is enabled or disabled for the integrated circuit 200). When the optional scan enable pad 215 is included, the scan reset control circuit 210 may receive the scan enable signal 217 at an optional scan enable input 216.

An optional functional reset multiplexer 264 may also be included in the integrated circuit 200. The optional functional reset multiplexer 264 may be configured to allow a functional reset signal 263 to be passed to the at least two circuit blocks 260 (i.e., a reset signal that is propagated during functional operation of the integrated circuit 200). For example, the optional functional reset multiplexer 264 may receive the scan enable signal 217 at a selector input to determine whether the scan reset control circuit 210 receives the reset signal 213 or the scan enable signal 217 at the single scan reset input 212. Of course, internal circuitry of the scan reset control circuit 210 may be adjusted when the optional functional reset multiplexer 264 is included to allow the functional reset signal 263 (whether asserted or deasserted) to pass through the scan reset control circuit 210 when the scan enable signal 217 is deasserted.

FIG. 3 illustrates an example reset enable circuit that is usable in a scan reset control circuit and includes a scan reset multiplexer in accordance with embodiments of the invention. The reset enable circuit of FIG. 3 may be a specific implementation of other reset enable circuits described herein such as the reset enable circuits of FIG. 1, for example. Similarly labeled elements may be as previously described.

Referring to FIG. 3, a reset enable circuit 320 includes a reset enable circuit input 322 configured to receive a reset signal 313, a reset enable circuit selector input 326 configured to receive a register output signal 337, and a reset enable circuit output 324 configured to output a circuit block-specific reset signal 318. In this specific example, the reset enable circuit 320 also includes a scan reset multiplexer 340 that receives the reset signal 313 at a first reset multiplexer input 341. A logical "1" signal 343 is coupled to a second reset multiplexer input 342. The register output signal 337 is received by the scan reset multiplexer 340 at a reset multiplexer selector input 346 and determines whether the reset signal 313 is output at a reset multiplexer output 344 of the scan reset multiplexer 340 (and ultimately at the reset enable circuit output 324).

FIG. 4 illustrates another example reset enable circuit that is usable in a scan reset control circuit and includes a scan enable multiplexer in addition to a scan reset multiplexer in accordance with embodiments of the invention. The reset enable circuit of FIG. 4 may be a specific implementation of other reset enable circuits described herein such as the reset enable circuits of FIG. 1, for example. Similarly labeled elements may be as previously described.

Referring to FIG. 4, a reset enable circuit 420 includes a reset enable circuit input 422 configured to receive a reset signal 413, a reset enable circuit selector input 426 configured to receive a register output signal 437, and a reset enable circuit output 424 configured to output a circuit block-specific reset signal 418. The reset enable circuit 420 also includes a circuit enable input 428 configured to receive a scan enable signal 417 (in contrast to the reset enable circuit 320 of FIG. 3, for example).

A scan reset multiplexer 440 receives the reset signal 413 at a first reset multiplexer input 441 and a logical "1" signal 443 at a second reset multiplexer input 442. The register output signal 437 is received by a scan enable multiplexer 450 at a first enable multiplexer input 451. A logical "0" signal 453 is coupled to a second enable multiplexer input 452. The scan enable signal 417 is received at a enable multiplexer selector input 456 and determines whether the register output signal 437 is output at an enable multiplexer output 454, which is coupled to a reset multiplexer selector input 446. This additional multiplexer factors the scan enable signal 417 into whether the reset signal 413 is output at a reset multiplexer output 444 of the scan reset multiplexer 440 (and then at the reset enable circuit output 424, as before).

FIG. 5 illustrates another example scan reset control circuit that includes a single register input coupled to a first register of a chain of writable non-scan test data registers configured in accordance with embodiments of the invention. The scan reset control circuit of FIG. 5 may be a specific implementation of other scan reset control circuits described herein such as the scan reset control circuit of FIG. 1, for example. Similarly labeled elements may be as previously described.

Referring to FIG. 5, a scan reset control circuit 510 includes a single scan reset input 512 and a plurality of reset enable circuits 520, each coupled to a respective scan reset output 514. The single scan reset input 512 is configured to receive a reset signal 513 that is provided to a reset enable circuit input 522 of each of the reset enable circuits 520. A plurality of test data registers 530 is included in this specific example and is configured to control the assertion or deassertion of the reset signal 513 at each scan reset output 514 using a reset pattern that is stored using a corresponding register input 532 of each test data register 530. The respective bits of the reset pattern are then provided at register outputs 534 of the plurality of test data registers 530 coupled to reset enable circuit selector inputs 526 of the reset enable circuits 520.

The scan reset control circuit 510 includes a plurality of reset enable circuits 520 that are each coupled to a corresponding scan reset output 514. Each of the reset enable circuits 520 generates a circuit block-specific reset signal 518 at a reset enable circuit output 524. As before, the scan reset control circuit 510 may also include an optional scan enable input 516 configured to receive a scan enable signal 517 that is provided to a respective optional circuit enable input 528 of the reset enable circuits 520. For example, this may extend the functionality of the scan reset control circuit 510 to allow the reset signal 513 to be pass through the scan reset control circuit 510 undisturbed when the optional scan enable signal 517 is deasserted.

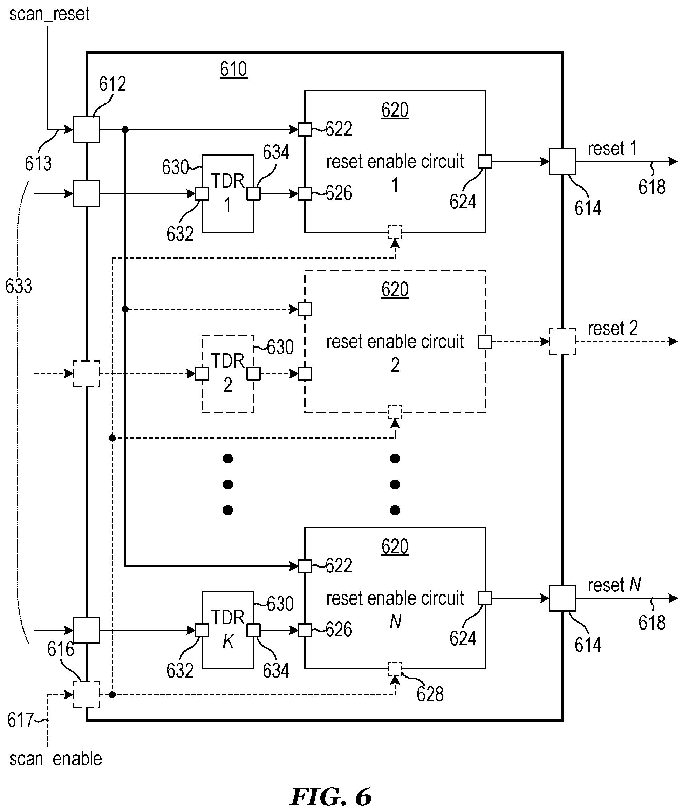

In this specific example, the plurality of test data registers 530 is implemented as a chain of test data registers 535. In particular, a first register 531 of the chain is coupled to a single register input 533 and the remaining registers are coupled to outputs of the previous register (i.e., configured to allow a reset pattern to be shifted into the chain of test data registers 535 using the single register input 533). FIG. 6 illustrates still another example scan reset control circuit that includes multiple register inputs coupled to writable non-scan test data registers in a one-to-one ratio in accordance with embodiments of the invention. The scan reset control circuit of FIG. 5 may be a specific implementation of other scan reset control circuits described herein such as the scan reset control circuit of FIG. 1, for example. Similarly labeled elements may be as previously described.

Referring to FIG. 6, a scan reset control circuit 610 includes a single scan reset input 612 and a plurality of reset enable circuits 620, each coupled to a respective scan reset output 614. The single scan reset input 612 is configured to receive a reset signal 613 that is provided to a reset enable circuit input 622 of each of the reset enable circuits 620. A plurality of test data registers 630 is included in this specific example and is configured to control the assertion or deassertion of the reset signal 613 at each scan reset output 614 using a reset pattern that is stored using a corresponding register input 632 of each test data register 630. The respective bits of the reset pattern are then provided at register outputs 634 of the plurality of test data registers 630 coupled to reset enable circuit selector inputs 626 of the reset enable circuits 620.

The scan reset control circuit 610 includes a plurality of reset enable circuits 620 that are each coupled to a corresponding scan reset output 614. Each of the reset enable circuits 620 generates a circuit block-specific reset signal 618 at a reset enable circuit output 624. As before, the scan reset control circuit 610 may also include an optional scan enable input 616 configured to receive a scan enable signal 617 that is provided to a respective optional circuit enable input 628 of the reset enable circuits 620. For example, this may extend the functionality of the scan reset control circuit 610 to allow the reset signal 613 to be pass through the scan reset control circuit 610 undisturbed when the optional scan enable signal 617 is deasserted.

Different from the scan reset control circuit 510 of FIG. 5, the register input 632 of each of the plurality of test data registers 630 is coupled to a plurality of register inputs 633 in a one-to-one ratio (e.g., to allow parallel loading of a reset pattern into the plurality of test data registers 630). This example and the example of FIG. 5 can be combined to any extent as desired. For example, two chains of test data registers may be included with two inputs to the scan reset control circuit and each chain may be any desired number of registers (whether the same or different). Of course, other combinations are possible as may be apparent to one of skill in the art based on this disclosure.

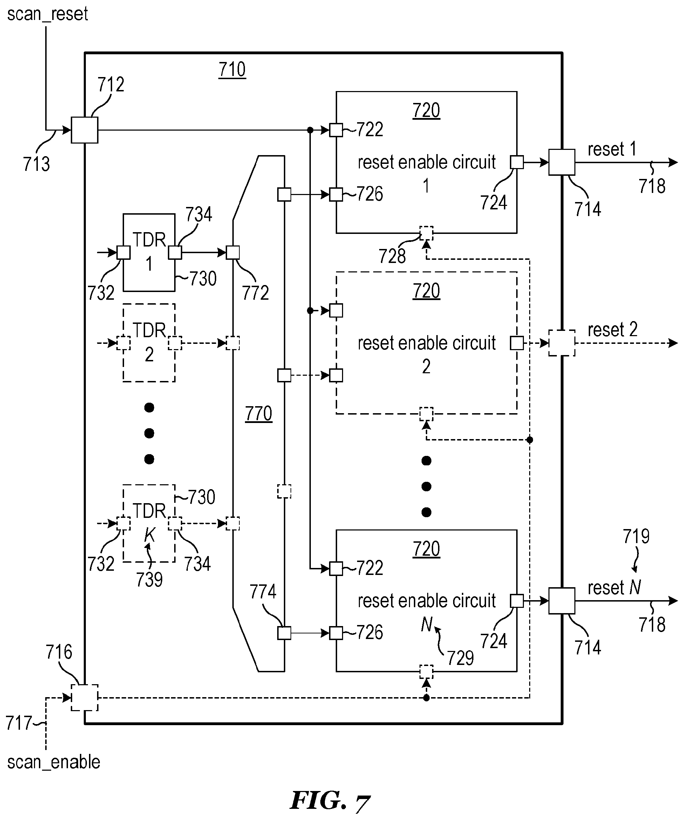

FIG. 7 illustrates yet another example scan reset control circuit that includes a decoder coupled between writable non-scan test data registers and reset enable circuits where the total number of the test data registers is less than the total number of the reset enable circuits in accordance with embodiments of the invention. The scan reset control circuit of FIG. 5 may be a specific implementation of other scan reset control circuits described herein such as the scan reset control circuit of FIG. 1, for example. Similarly labeled elements may be as previously described.

Referring to FIG. 7, a scan reset control circuit 710 includes a single scan reset input 712 and a plurality of reset enable circuits 720, each coupled to a respective scan reset output 714. The single scan reset input 712 is configured to receive a reset signal 713 that is provided to a reset enable circuit input 722 of each of the reset enable circuits 720. A plurality of test data registers 730 is included in this specific example and is configured to control the assertion or deassertion of the reset signal 713 at each scan reset output 714 using a reset pattern that is stored using a corresponding register input 732 of each test data register 730. The respective bits of the reset pattern are then provided at register outputs 734 of the plurality of test data registers 730 coupled to reset enable circuit selector inputs 726 of the reset enable circuits 720.

The scan reset control circuit 710 includes a plurality of reset enable circuits 720 that are each coupled to a corresponding scan reset output 714. Each of the reset enable circuits 720 generates a circuit block-specific reset signal 718 at a reset enable circuit output 724. As before, the scan reset control circuit 710 may also include an optional scan enable input 716 configured to receive a scan enable signal 717 that is provided to a respective optional circuit enable input 728 of the reset enable circuits 720. For example, this may extend the functionality of the scan reset control circuit 710 to allow the reset signal 713 to be pass through the scan reset control circuit 710 undisturbed when the optional scan enable signal 717 is deasserted.

In this specific example, a total number of register outputs 739 is less than a total number of reset enable circuits 729 (and consequently also less than a total number of scan reset outputs 719, which is equal to total number of reset enable circuits 729). A decoder 770 is included to decode the reset pattern in the plurality of test data registers 730 into the bit map identifying whether each circuit block-specific reset signal 718 is asserted. The decoder 770 includes a decoder input 772 coupled to each of the register outputs 734. Similarly, the decoder 770 also includes a decoder output 774 coupled to each reset enable circuit selector inputs 726 of the plurality of reset enable circuits 720. To match the respective numbers of reset enable circuits 720 (*N*) and test data registers 730 *(K),* the number of inputs of the decoder 770 is less than the number of outputs.

Some amount of space may be saved by including the decoder 770. For example, when a predefined number of possible reset patterns is already known for a design (e.g., P), the number of test data registers 730 K may be decreased to the minimum value of *K* for which *P* ≤ 2*^{K}.* On the other hand, the degree to which *K* is less than N may also reflect a reduction in the configuration flexibility for the scan reset control circuit 710. That is, fewer test data registers 730 than reset enable circuits 720 eliminates possible reset patterns which may or may not be desirable in some circumstances and may depend on how much is known about the IR drop and circuit blocks of a given design before the scan reset control circuit 710 is fabricated.

FIG. 8 illustrates an example integrated circuit that includes a scan reset control circuit in top system-on-chip logic of the integrated circuit as well as six circuit blocks of different relative size and location in accordance with embodiments of the invention.

Referring to FIG. 8, an integrated circuit 800 includes a plurality of circuit blocks 860 (here six, but of course any number greater than one is possible). A scan reset control circuit 810 is included in top logic of the integrated circuit 800 (for instance, in this case the integrated circuit 800 is a system-on-chip, SoC and the scan reset control circuit 810 is included in top SoC logic 811 of the integrated circuit 800). This schematic layout of the circuit blocks 860 of the integrated circuit 800 is provided merely by way of example to aid in the discussion of several possible reset pattern paradigms.

The circuit blocks 860 exemplified in Figure 8 that are reset simultaneously may be determined based on the details of a given design. For example, IR drop analysis may be performed to assess the impact of resetting certain circuit blocks together or separately. In some cases, each circuit block may be reset separately while in other cases only two groups of circuit blocks need be identified to prevent the IR drop from exceeding a safe threshold (e.g., a predetermined threshold determined to be safe for a given design).

Certain parameters may be considered instead of or in addition to IR drop analysis. For example, the physical locations of the circuit blocks 860 may be considered when determining which circuit blocks 860 to reset simultaneously. In various embodiments, reset patterns may avoid resetting adjacent circuit blocks at the same time (e.g., circuit block 3 and circuit block 4 are not switched together while circuit block 3 and circuit clock 1 can be switched together).

Another parameter that may be used is the number of flip-flops that are being switched in each circuit block. The number of flip-flops can be different between circuit blocks. One methodology of determining appropriate reset patterns may be to balance the number of flip-flops that are switched at the same time between reset patterns (to the extent possible) with all reset patterns simultaneously switching a number of flip-flops below a predetermined threshold (e.g., that has been determined based on estimated, calculated, or measure IR drop per flip-flop and an IR drop threshold that is determined to be safe for the design).

FIG. 9 illustrates an example method of testing an integrated circuit in accordance with embodiments of the invention. The method of FIG. 9 may be combined with other methods and performed using the systems and apparatuses as described herein. For example, the method of FIG. 9 may be combined with any of the embodiments of FIGS. 1-8. Although shown in a logical order, the arrangement and numbering of the steps of FIG. 9 are not intended to be limited. The method steps of FIG. 9 may be performed in any suitable order or concurrently with one another as may be apparent to a person of skill in the art.

Referring to FIG. 9, a method 900 of testing an integrated circuit that includes multiple circuit blocks includes a block 901 of storing a reset pattern in a plurality of writable non-scan test data registers of the integrated circuit. In block 902, a scan reset signal is asserted at a scan reset pad of the integrated circuit (e.g., to test for reset faults). Then, using the reset pattern, the scan reset signal is deasserted to a subset of circuit blocks of a plurality of circuit blocks of the integrated circuit and asserted to the remaining circuit blocks (all those not in the subset of circuit blocks) in block 903 and block 904, respectively. The scan reset signal is either asserted or deasserted at outputs of the writable non-scan test data registers using the reset pattern.

A test pattern is then launched in block 905 while the scan reset signal is deasserted to the subset of circuit blocks and asserted to the remaining circuit blocks. In block 906, the results of the test pattern are captured. In block 905, the test pattern may already be in sets of scan flip-flops (each set belonging to a corresponding circuit block of the integrated circuit). For example, the test pattern may be shifted into the sets of scan flip-flops in an optional block 907.

The method 900 may optionally be repeated as part of a cycle, as shown by the arrow 909. For example, the method 900 may be repeated with different rest patterns in order to pulse the reset signals to circuit blocks that were previously disabled while other circuit blocks were tested. Specifically, a second reset pattern may be stored in the plurality of writable non-scan test data registers (block 901) and the scan reset signal may be deasserted to a second subset of circuit blocks and asserted to the remaining circuit blocks (block 903 and block 904). A second test pattern may then be launched and captured in block 905 and block 906, respectively. Notably, the second test pattern may be the same as the first test pattern (i.e., optional block 907 would be omitted during the second cycle of the method 900) or may be a different test pattern (e.g., that is shifted in during the optional block 907).

At times, the same circuit block may be deasserted multiple times (i.e., when more than two cycles are desired to test all of the circuit blocks). For example, a third reset pattern may be stored in the plurality of writable non-scan test data registers (block 901) and the scan reset signal may be deasserted to a third subset of circuit blocks and asserted to the remaining circuit blocks (block 903 and block 904). A third test pattern (similar or different than the first and second test patterns) may then be launched and captured in block 905 and block 906, respectively. The first and second subset may include at least one common circuit block that is then tested (whether excluded from the third subset and tested with the third test pattern or excluded from a future subset of circuit blocks).

Various methodologies may be utilized to determine which circuit blocks to test simultaneously. As discussed above, the test patterns may be determined based on IR drop analysis. That is, each subset of circuit blocks may be selected to limit IR drop to within a predetermined threshold in the integrated circuit during the launching of a test pattern based on IR drop analysis. In some cases physical proximity may be an important factor in determining which circuit blocks may be simultaneously reset. For example, subsets of circuit blocks may be selected so that the remaining circuit blocks (i.e., those being reset) are physically separated from one another. Another possible factor may be the total number of flip-flops being reset at the same time. For example, subsets of circuit blocks may be selected to limit the number of flip-flops in the remaining circuit blocks to a predetermined value to mitigate IR drop in the integrated circuit during the launching of test patterns. Of course, any of these (and other) methodologies may be combined as desired based on the specific details of a given application.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A scan reset control circuit (110; 210; 510; 610; 710; 810), comprising:
a single scan reset input node (112; 212; 512; 612; 712) configured to receive a reset signal (scan_reset);
a plurality of scan reset output nodes (114; 214; 514; 614; 714) configured to be coupled to a plurality of circuit blocks (260) in a one-to-one ratio, each scan reset output node of the plurality of scan reset output nodes (114; 214; 514; 614; 714) configured to simultaneously reset a set of scan flip-flops (262) of the corresponding circuit block of the plurality of circuit blocks (260);
a plurality of writable test data registers (130; 530; 630; 730) comprising test data register outputs (134; 534; 634; 734) configured to assert or deassert the reset signal (scan_reset); and
a plurality of reset enable circuits (120; 320; 420) coupled to the plurality of scan reset outputs (114; 214; 514; 614; 714) in a one-to-one ratio, each reset enable circuits of the plurality of reset enable circuits (120; 320; 420) comprising:
an input node (122; 322; 422) coupled to the single scan reset input node (112; 212; 512; 612; 712),
a selector input node (126; 326; 426) coupled to the test data register outputs (134; 534; 634; 734), and
an output node (124; 324; 424) coupled to a corresponding scan reset output of the plurality of scan reset outputs (114; 214; 514; 614; 714).

2. The scan reset control circuit (110; 210; 510; 610; 710; 810) of claim 1, wherein each of the plurality of reset enable circuits of the plurality of reset enable circuits (120; 320; 420) comprises a scan reset multiplexer (340; 440) comprising
a first reset multiplexer input node (341, 441) coupled to the single scan reset input node (322, 422),
a second reset multiplexer input node (342, 442) coupled to a logical one signal (343, 443),
a reset multiplexer selector input node (346, 446) coupled to the test data register outputs (134; 534; 634; 734), and
a reset multiplexer output node (344; 444) coupled to the corresponding scan reset output node (324, 424).

3. The scan reset control circuit (110; 210; 510; 610; 710; 810) of claim 2, wherein each reset enable circuit of the plurality of reset enable circuits (120; 320; 420) further comprises a scan enable multiplexer (450) coupled between the test data register outputs (134; 534; 634; 734) and the selector multiplexer input node (446)of the corresponding scan reset multiplexer (440), the scan enable multiplexer (450) comprising
a first enable multiplexer input (451) coupled to the test data register outputs (134; 534; 634; 734),
a second enable multiplexer input node coupled to a logical zero signal (453),
an enable multiplexer selector input node (456) coupled to a scan enable signal (417),
an enable multiplexer output node (454) coupled to the reset multiplexer selector input node (446) of the corresponding scan reset multiplexer (440).

4. The scan reset control circuit (110; 210; 510; 610; 710; 810) of claim 1, further comprising:
a single register input node (533) coupled to a first register (531) of the plurality of writable test data registers (530), the test data registers of the plurality of writable test data registers (530) being arranged as a chain of test data registers (535) configured to shift data values received at the single register input (533) through the chain (535), preferably wherein the scan reset control circuit further comprises a plurality of register inputs (633) coupled to the plurality of writable test data registers (630) in a one-to-one ratio.

5. The scan reset control circuit (110; 210; 510; 610; 710; 810) of claim 1, wherein the total number of scan reset output nodes (114; 214; 514; 614; 714) and the total number of register outputs (134; 534; 634; 734) of the plurality of writable test data registers (130; 530; 630; 730) are equal.

6. The scan reset control circuit (110; 210; 510; 610; 710; 810) of claim 1, further comprising:
a decoder (770) comprising
a plurality of decoder input nodes (772), each decoder input node of the plurality of decoder input nodes (772) coupled to a corresponding test data register output (134; 534; 634; 734) of the plurality of writable test data registers (130; 530; 630; 730)in a one-to-one ratio, and
a plurality of decoder output nodes (774), each decoder output node of the plurality of decoder output nodes (774) coupled to a corresponding input node of a respective reset enable circuit of the plurality of reset enable circuits (120; 320; 420) in a one-to-one ratio,
wherein the total number of scan reset output nodes is greater than the total number of test data register outputs (134; 534; 634; 734) of the plurality of writable test data registers (130; 530; 630; 730).

7. An integrated circuit (200; 800), comprising:
a scan reset pad (211) configured to receive a reset signal (external scan_reset, 218) external to the integrated circuit (800);
a plurality of circuit blocks (260; 860) comprising a set of scan flip-flops configured to be simultaneously reset by the reset signal (external scan_reset, 218);
a plurality of writable test data registers (130) comprising test data register outputs (134) configured to assert or de-assert the reset signal (external scan_reset); and
a plurality of reset enable circuits (120) coupled to the plurality of circuit blocks (260; 860) in a one-to-one ratio, each of the plurality of reset enable circuits (120) comprising
an input node (122) coupled to the scan reset pad (211),
a selector input node (126) coupled to the test data register outputs (134), and
an output node (124) coupled to the corresponding circuit block (260).

8. The integrated circuit (200; 800) of claim 7,
wherein each of the plurality of reset enable circuits (120) comprises a plurality of scan reset multiplexers (340, 440) each comprising
a first reset multiplexer input node coupled to the scan reset pad (211),
a second reset multiplexer input node coupled to a logical one signal,
a reset multiplexer selector input node coupled to the test data register outputs, and
a reset multiplexer output node coupled to the corresponding scan reset output node.

9. The integrated circuit (200; 800) of claim 8, further comprising:
a scan enable pad (215) configured to receive a scan enable signal (external_scan_enable) external to the integrated circuit (200; 800), the scan enable signal (external_scan_enable) being configured to simultaneously assert the test data register outputs or deassert the reset signal,
wherein each of the plurality of reset enable circuits (120) further comprises a plurality of scan enable multiplexers (450) coupled between the register outputs and the selector input of the corresponding scan reset multiplexer (340, 440), each of the plurality of scan enable multiplexers (450) comprising:
a first enable multiplexer input node coupled to the test data register outputs,
a second enable multiplexer input node coupled to a logical zero signal,
an enable multiplexer selector input node coupled to the scan enable pad (215), and
an enable multiplexer output node coupled to the reset multiplexer selector input node of the corresponding scan reset multiplexer (450), preferably wherein the total number of scan reset outputs and the total number of test data register outputs of the plurality of writable test data registers are equal.

10. The integrated circuit (200; 800) of claim 7, further comprising:
a decoder (770) comprising
a plurality of decoder input nodes (772) each coupled to a corresponding test data register output (734) of the plurality of writable test data registers (720) in a one-to-one ratio, and
a plurality of decoder output nodes (774) each coupled to a corresponding input node (722) of reset enable circuits of the plurality of reset enable circuits (720) in a one-to-one ratio,
wherein the total number of scan reset outputs (714) is greater than the total number of test data register outputs (734) of the plurality of writable test data registers (730).

11. A method (900) of testing an integrated circuit (200; 800) according to any one of claims 7 to 10, the method comprising:
shifting (907) a first test pattern into a plurality of sets of scan flip-flops of the integrated circuit (200; 800), each set of scan flip-flops being comprised within a corresponding circuit block of the plurality of circuit blocks (260; 860) of the integrated circuit (200; 800) in a one-to-one ratio;
storing (901) a first reset pattern in a plurality of writable test data registers (130) of the integrated circuit (200; 800);
asserting (902) a scan reset signal at a scan reset pad of the integrated circuit (200; 800) to test for reset faults;
deasserting (903) the scan reset signal to a first subset of circuit blocks of the plurality of circuit blocks (260; 860) of the integrated circuit (200; 800) and asserting (904) the scan reset signal to the remaining circuit blocks not in the first subset at outputs of the writable test data registers (130) using the first reset pattern;
launching (905) the first test pattern while the scan reset signal is deasserted to the first subset of circuit blocks and asserted to the remaining circuit blocks not in the first subset; and
capturing (906) results of the first test pattern.

12. The method (900) of claim 11, further comprising:
storing a second reset pattern in the plurality of writable test data registers (130);
deasserting the scan reset signal to a second subset of circuit blocks of the plurality of circuit blocks and asserting the scan reset signal to the remaining circuit blocks not in the second subset at outputs of the writable test data registers (130) using the second reset pattern;
launching a second test pattern while the scan reset signal is deasserted to the second subset of circuit blocks and asserted to the remaining circuit blocks not in the second subset; and
capturing results of the second test pattern,
preferably wherein the second test pattern is the same as the first test pattern.

13. The method of claim 11, further comprising:
storing a third reset pattern in the plurality of writable non-scan test data registers;
deasserting the scan reset signal to a third subset of circuit blocks of the plurality of circuit blocks and asserting the scan reset signal to the remaining circuit blocks not in the third subset at outputs of the writable non-scan test data registers using the third reset pattern, the first subset and the second subset having at least one common circuit block;
launching a third test pattern while the scan reset signal is deasserted to the third subset of circuit blocks and asserted to the remaining circuit blocks not in the third subset; and
capturing results of the third test pattern.

14. The method of claim 13, wherein:
the method further comprises shifting the second test pattern into the plurality of sets of scan flip-flops before launching the second test pattern, the second test pattern being different than the first test pattern, and/or
the first subset of circuit blocks is selected to limit IR drop to within a predetermined threshold in the integrated circuit (200; 800) during the launching (905) of the first test pattern based on IR drop analysis.

15. The method of claim 11, wherein:
- the first subset of circuit blocks is selected so that the remaining circuit blocks not in the first subset are physically separated from one another, and/or
- the first subset of circuit blocks is selected to limit the number of flip-flops in the remaining circuit blocks not in the first subset to a predetermined value to mitigate IR drop in the integrated circuit (200; 800) during the launching (905) of the first test pattern.

## Patentansprüche

1. Scan-Reset-Steuerschaltung (no; 210; 510; 610; 710; 810), umfassend:
einen Einzelscan-Reset-Eingangsknoten (112; 212; 512; 612; 712), der so konfiguriert ist, dass er ein Reset-Signal (scan_reset) empfängt;
eine Vielzahl von Scan-Reset-Ausgangsknoten (114; 214; 514; 614; 714), die so konfiguriert sind, dass sie mit einer Vielzahl von Schaltungsblöcken (260) in einem Eins-zu-Eins-Verhältnis gekoppelt sind, wobei jeder Scan-Reset-Ausgangsknoten der Vielzahl von Scan-Reset-Ausgangsknoten (114; 214; 514; 614; 714) so konfiguriert ist, dass er gleichzeitig einen Satz von Scan-Flip-Flops (262) des entsprechenden Schaltungsblocks der Vielzahl von Schaltungsblöcken (260) zurücksetzt;
eine Vielzahl von beschreibbaren Testdatenregistern (130; 530; 630; 730), die Testdatenregisterausgänge (134; 534; 634; 734) umfassen, die so konfiguriert sind, dass sie das Reset-Signal (scan_reset) aktivieren oder deaktivieren; und
eine Vielzahl von Reset-Freigabeschaltungen (120; 320; 420), die mit der Vielzahl von Scan-Reset-Ausgängen (114; 214; 514; 614; 714) in einem Eins-zu-Eins-Verhältnis gekoppelt sind, wobei jede Reset-Freigabeschaltung der Vielzahl von Reset-Freigabeschaltungen (120; 320; 420) umfasst:
einen Eingangsknoten (122; 322; 422), der mit dem Einzelscan-Reset-Eingangsknoten (112; 212; 512; 612; 712) gekoppelt ist,
einen Selektor-Eingangsknoten (126; 326; 426), der mit den Testdatenregisterausgängen (134; 534; 634; 734) gekoppelt ist, und
einen Ausgangsknoten (124; 324; 424), der mit einem entsprechenden Scan-Reset-Ausgang der Vielzahl von Scan-Reset-Ausgängen (114; 214; 514; 614; 714) gekoppelt ist.

2. Scan-Reset-Steuerschaltung (110; 210; 510; 610; 710; 810) nach Anspruch 1, wobei jede der Vielzahl von Reset-Freigabeschaltungen der Vielzahl von Reset-Freigabeschaltungen (120; 320; 420) einen Scan-Reset-Multiplexer (340; 440) umfasst, umfassend
einen ersten Reset-Multiplexer-Eingangsknoten (341, 441), der mit dem Einzelscan-Reset-Eingangsknoten (322, 422) gekoppelt ist,
einen zweiten Reset-Multiplexer-Eingangsknoten (342, 442), der mit einem logischen Eins-Signal (343, 443) gekoppelt ist,
einen Reset-Multiplexer-Selektor-Eingangsknoten (346, 446), der mit den Testdatenregisterausgängen (134; 534; 634; 734) gekoppelt ist, und
einen Reset-Multiplexer-Ausgangsknoten (344; 444), der mit dem entsprechenden Scan-Reset-Ausgangsknoten (324, 424) gekoppelt ist.

3. Scan-Reset-Steuerschaltung (110; 210; 510; 610; 710; 810) nach Anspruch 2, wobei jede Reset-Freigabeschaltung der Vielzahl von Reset-Freigabeschaltungen (120; 320; 420) ferner einen Scan-Freigabe-Multiplexer (450) umfasst, der zwischen den Testdatenregisterausgängen (134; 534; 634; 734) und dem Selektor-Multiplexer-Eingangsknoten (446) des entsprechenden Scan-Reset-Multiplexers (440) gekoppelt ist, wobei der Scan-Freigabe-Multiplexer (450) umfasst:
einen ersten Freigabe-Multiplexer-Eingang (451), der mit den Testdatenregisterausgängen (134; 534; 634; 734) gekoppelt ist,
einen zweiten Freigabe-Multiplexer-Eingangsknoten, der mit einem logischen Null-Signal (453) gekoppelt ist,
einen Freigabe-Multiplexer-Selektor-Eingangsknoten (456), der mit einem Scan-Freigabesignal (417) gekoppelt ist,
einen Freigabe-Multiplexer-Ausgangsknoten (454), der mit dem Reset-Multiplexer-Selektor-Eingangsknoten (446) des entsprechenden Scan-Reset-Multiplexers (440) gekoppelt ist.

4. Scan-Reset-Steuerschaltung (110; 210; 510; 610; 710; 810) nach Anspruch 1, ferner umfassend:
einen einzelnen Registereingangsknoten (533), der mit einem ersten Register (531) der Vielzahl von beschreibbaren Testdatenregistern (530) gekoppelt ist, wobei die Testdatenregister der Vielzahl von beschreibbaren Testdatenregistern (530) als Kette von Testdatenregistern (535) angeordnet sind, die so konfiguriert sind, dass sie Datenwerte, die an dem Eingang des einzelnen Registers (533) empfangen werden, durch die Kette (535) verschieben, wobei die Scan-Reset-Steuerschaltung ferner eine Vielzahl von Registereingängen (633) umfasst, die mit der Vielzahl von beschreibbaren Testdatenregistern (630) im Eins-zu-Eins-Verhältnis gekoppelt sind.

5. Scan-Reset-Steuerschaltung (110; 210; 510; 610; 710; 810) nach Anspruch 1, wobei die Gesamtzahl der Scan-Reset-Ausgangsknoten (114; 214; 514; 614; 714) und die Gesamtzahl der Registerausgänge (134; 534; 634; 734) der Vielzahl von beschreibbaren Testdatenregistern (130; 530; 630; 730) gleich sind.

6. Scan-Reset-Steuerschaltung (110; 210; 510; 610; 710; 810) nach Anspruch 1, ferner umfassend:
einen Decoder (770), umfassend
eine Vielzahl von Decoder-Eingangsknoten (772), wobei jeder Decoder-Eingangsknoten der Vielzahl von Decoder-Eingangsknoten (772) mit einem entsprechenden Testdatenregisterausgang (134; 534; 634; 734) der Vielzahl von beschreibbaren Testdatenregistern (130; 530; 630; 73O) in einem Eins-zu-Eins-Verhältnis gekoppelt ist, und
eine Vielzahl von Decoder-Ausgangsknoten (774), wobei jeder Decoder-Ausgangsknoten der Vielzahl von Decoder-Ausgangsknoten (774) mit einem entsprechenden Eingangsknoten einer jeweiligen Reset-Freigabeschaltung der Vielzahl von Reset-Freigabeschaltungen (120; 320; 420) im Eins-zu-Eins-Verhältnis gekoppelt ist,
wobei die Gesamtzahl der Scan-Reset-Ausgangsknoten größer ist als die Gesamtzahl der Testdatenregisterausgänge (134; 534; 634; 734) der Vielzahl von beschreibbaren Testdatenregistern (130; 530; 630; 730).

7. Integrierte Schaltung (200; 800), umfassend:
ein Scan-Reset-Pad (211), das so konfiguriert ist, dass es ein Reset-Signal (external scan_reset, 218) außerhalb der integrierten Schaltung (800) empfängt;
eine Vielzahl von Schaltungsblöcken (260; 860), die einen Satz von Scan-Flip-Flops umfassen, die so konfiguriert sind, dass sie gleichzeitig durch das Reset-Signal (external scan_reset, 218) zurückgesetzt werden;
eine Vielzahl von beschreibbaren Testdatenregistern (130), die Testdatenregisterausgänge (134) umfassen, die so konfiguriert sind, dass sie das Reset-Signal (externer scan_reset) aktivieren oder deaktivieren; und
eine Vielzahl von Reset-Freigabeschaltungen (120), die mit der Vielzahl von Schaltungsblöcken (260; 860) in einem Eins-zu-Eins-Verhältnis gekoppelt sind, wobei jede der Vielzahl von Reset-Freigabeschaltungen (120) umfasst:
einen Eingangsknoten (122), der mit dem Scan-Reset-Pad (211) gekoppelt ist,
einen Selektor-Eingangsknoten (126), der mit den Testdatenregisterausgängen (134) gekoppelt ist, und
einen Ausgangsknoten (124), der mit dem entsprechenden Schaltungsblock (260) gekoppelt ist.

8. Integrierte Schaltung (200; 800) nach Anspruch 7,
wobei jede der Vielzahl von Reset-Freigabeschaltungen (120) eine Vielzahl von Scan-Reset-Multiplexern (340, 440) umfasst, die jeweils umfassen:
einen ersten Reset-Multiplexer-Eingangsknoten, der mit dem Scan-Reset-Pad (211) gekoppelt ist,
einen zweiten Reset-Multiplexer-Eingangsknoten, der an ein logisches Eins-Signal gekoppelt ist,
einen Reset-Multiplexer-Selektor-Eingangsknoten, der mit den Testdatenregisterausgängen gekoppelt ist, und
einen Reset-Multiplexer-Ausgangsknoten, der mit dem entsprechenden Scan-Reset-Ausgangsknoten gekoppelt ist.

9. Integrierte Schaltung (200; 800) nach Anspruch 8, ferner umfassend:
ein Scan-Freigabe-Pad (215), das so konfiguriert ist, dass es ein Scan-Freigabesignal (external_scan_enable) außerhalb der integrierten Schaltung (200; 800) empfängt, wobei das Scan-Freigabesignal (external_scan_enable) so konfiguriert ist, dass es gleichzeitig die Testdatenregisterausgänge aktiviert oder das Reset-Signal deaktiviert,
wobei jede der Vielzahl von Reset-Freigabeschaltungen (120) ferner eine Vielzahl von Scan-Freigabe-Multiplexern (450) umfasst, die zwischen den Registerausgängen und dem Selektor-Eingang des entsprechenden Scan-Reset-Multiplexers (340, 440) gekoppelt sind, wobei jeder der Vielzahl von Scan-Freigabe-Multiplexern (450) Folgendes umfasst:
einen ersten Freigabe-Multiplexer-Eingangsknoten, der mit den Testdatenregisterausgängen gekoppelt ist,
einen zweiten Freigabe-Multiplexer-Eingangsknoten, der mit einem logischen Null-Signal gekoppelt ist,
einen Freigabe-Multiplexer-Selektor-Eingangsknoten, der mit dem Scan-Freigabe-Pad (215) gekoppelt ist, und
einen Freigabe-Multiplexer-Ausgangsknoten, der mit dem Reset-Multiplexer-Selektor-Eingangsknoten des entsprechenden Scan-Reset-Multiplexers (450) gekoppelt ist, wobei vorzugsweise die Gesamtzahl der Scan-Reset-Ausgänge und die Gesamtzahl der Testdatenregisterausgänge der Vielzahl von beschreibbaren Testdatenregistern gleich sind.

10. Integrierte Schaltung (200; 800) nach Anspruch 7, ferner umfassend:
einen Decoder (770), umfassend
eine Vielzahl von Decoder-Eingangsknoten (772), die jeweils mit einem entsprechenden Testdatenregisterausgang (734) der Vielzahl von beschreibbaren Testdatenregistern (720) in einem Eins-zu-Eins-Verhältnis gekoppelt sind, und eine Vielzahl von Decoder-Ausgangsknoten (774), die jeweils mit einem entsprechenden Eingangsknoten (722) von Reset-Freigabeschaltungen der Vielzahl von Reset-Freigabeschaltungen (720) in einem Eins-zu-Eins-Verhältnis gekoppelt sind,
wobei die Gesamtzahl der Scan-Reset-Ausgänge (714) größer ist als die Gesamtzahl der Testdatenregisterausgänge (734) der Vielzahl von beschreibbaren Testdatenregistern (730).

11. Verfahren (900) zum Testen einer integrierten Schaltung (200; 800) nach einem der Ansprüche 7 bis 10, wobei das Verfahren Folgendes umfasst:
Verschieben (907) eines ersten Testmusters in eine Vielzahl von Sätzen von Scan-Flip-Flops der integrierten Schaltung (200; 800), wobei jeder Satz von Scan-Flip-Flops in einem entsprechenden Schaltungsblock der Vielzahl von Schaltungsblöcken (260; 860) der integrierten Schaltung (200; 800) in einem Eins-zu-Eins-Verhältnis eingeschlossen ist;
Speichern (901) eines ersten Reset-Musters in einer Vielzahl von beschreibbaren Testdatenregistern (130) der integrierten Schaltung (200; 800);
Aktivieren (902) eines Scan-Reset-Signals an einem Scan-Reset-Pad der integrierten Schaltung (200; 800), um auf Reset-Fehler zu testen;
Deaktivieren (903) des Scan-Reset-Signals für einen ersten Untersatz von Schaltungsblöcken der Vielzahl von Schaltungsblöcken (260; 860) der integrierten Schaltung (200; 800) und Aktivieren (904) des Scan-Reset-Signals für die verbleibenden Schaltungsblöcke, die sich nicht in dem ersten Untersatz befinden, an Ausgängen der beschreibbaren Testdatenregister (130) unter Verwendung des ersten Reset-Musters;
Starten (905) des ersten Testmusters, während das Scan-Reset-Signal für den ersten Untersatz von Schaltungsblöcken deaktiviert und für die verbleibenden Schaltungsblöcke, die sich nicht in dem ersten Untersatz befinden, aktiviert wird; und
Erfassen (906) der Ergebnisse des ersten Testmusters.

12. Verfahren (900) nach Anspruch 11, ferner umfassend:
Speichern eines zweiten Reset-Musters in der Vielzahl von beschreibbaren Testdatenregistern (130);
Deaktivieren des Scan-Reset-Signals für einen zweiten Untersatz von Schaltungsblöcken der Vielzahl von Schaltungsblöcken und Aktivieren des Scan-Reset-Signals für die verbleibenden Schaltungsblöcke, die sich nicht in dem zweiten Untersatz befinden, an Ausgängen der beschreibbaren Testdatenregister (130) unter Verwendung des zweiten Reset-Musters;
Starten eines zweiten Testmusters, während das Scan-Reset-Signal für den zweiten Untersatz von Schaltungsblöcken deaktiviert und für die verbleibenden Schaltungsblöcke, die sich nicht in dem zweiten Untersatz befinden, aktiviert wird; und
Erfassen der Ergebnisse des zweiten Testmusters,
wobei vorzugsweise das zweite Testmuster dasselbe ist wie das erste Testmuster.

13. Verfahren nach Anspruch 11, ferner umfassend:
Speichern eines dritten Reset-Musters in der Vielzahl von beschreibbaren Nicht-Scan-Testdatenregistern;
Deaktivieren des Scan-Reset-Signals für einen dritten Untersatz von Schaltungsblöcken der Vielzahl von Schaltungsblöcken und Aktivieren des Scan-Reset-Signals für die verbleibenden Schaltungsblöcke, die sich nicht in dem dritten Untersatz befinden, an Ausgängen der beschreibbaren Nicht-Scan-Testdatenregister unter Verwendung des dritten Reset-Musters, wobei der erste Untersatz und der zweite Untersatz mindestens einen gemeinsamen Schaltungsblock aufweisen;
Starten eines dritten Testmusters, während das Scan-Reset-Signal für den dritten Untersatz von Schaltungsblöcken deaktiviert und für die verbleibenden Schaltungsblöcke, die sich nicht in dem dritten Untersatz befinden, aktiviert wird; und
Erfassen der Ergebnisse des dritten Testmusters.

14. Verfahren nach Anspruch 13, wobei:
das Verfahren ferner das Verschieben des zweiten Testmusters in die Vielzahl von Sätzen von Scan-Flip-Flops vor dem Starten des zweiten Testmusters umfasst, wobei sich das zweite Testmuster von dem ersten Testmuster unterscheidet, und/oder
der erste Untersatz von Schaltungsblöcken ausgewählt wird, um den IR-Abfall während des Startens (905) des ersten Testmusters innerhalb eines vorbestimmten Schwellenwerts in der integrierten Schaltung (200; 800) zu begrenzen, basierend auf der Analyse des IR-Abfalls.

15. Verfahren nach Anspruch 11, wobei:
- der erste Untersatz von Schaltungsblöcken so ausgewählt wird, dass die verbleibenden Schaltungsblöcke, die sich nicht in dem ersten Untersatz befinden, physisch voneinander getrennt sind, und/oder
- der erste Untersatz von Schaltungsblöcken ausgewählt wird, um die Anzahl der Flip-Flops in den verbleibenden Schaltungsblöcken, die sich nicht in dem ersten Untersatz befinden, auf einen vorbestimmten Wert zu begrenzen, um den IR-Abfall in der integrierten Schaltung (200; 800) während des Startens (905) des ersten Testmusters zu verringern.

## Revendications

1. Circuit de commande de réinitialisation d'analyse (110 ; 210 ; 510 ; 610 ; 710 ; 810) comprenant :
un seul nœud d'entrée de réinitialisation d'analyse (112 ; 212 ; 512 ; 612 ; 712) configuré pour recevoir un signal de réinitialisation (scan_reset) ;
une pluralité de nœuds de sortie de réinitialisation d'analyse (114 ; 214 ; 514 ; 614 ; 714) configurée pour être couplée à une pluralité de blocs de circuit (260) dans un rapport de un à un, chaque nœud de sortie de réinitialisation d'analyse de la pluralité de nœuds de sortie de réinitialisation d'analyse (114 ; 214 ; 514 ; 614 ; 714) étant configuré pour réinitialiser simultanément un ensemble de bascules d'analyse (262) du bloc de circuit correspondant de la pluralité de blocs de circuit (260) ;
une pluralité de registres de données de test modifiables (130 ; 530 ; 630 ; 730) comprenant des sorties de registres de données de test (134 ; 534 ; 634 ; 734) configurées pour activer ou désactiver le signal de réinitialisation (scan_reset) ; et
une pluralité de circuits de validation de réinitialisation (120 ; 320 ; 420) couplée à la pluralité de sorties de réinitialisation d'analyse (114 ; 214 ; 514 ; 614 ; 714) dans un rapport de un à un, chaque circuit de validation de réinitialisation de la pluralité de circuits de validation de réinitialisation (120 ; 320 ; 420) comprenant :
un nœud d'entrée (122 ; 322 ; 422) couplé au nœud d'entrée de réinitialisation d'analyse (112 ; 212 ; 512 ; 612 ; 712),
un nœud d'entrée de sélecteur (126 ; 326 ; 426) couplé aux sorties de registres de données de test (134 ; 534 ; 634 ; 734), et
un nœud de sortie (124 ; 324 ; 424) couplé à une sortie de réinitialisation d'analyse correspondante de la pluralité de sorties de réinitialisation d'analyse (114 ; 214 ; 514 ; 614 ; 714).

2. Circuit de commande de réinitialisation d'analyse (110 ; 210 ; 510 ; 610 ; 710 ; 810) selon la revendication 1, dans lequel chaque circuit de validation de réinitialisation de la pluralité de circuits de validation de réinitialisation (120 ; 320 ; 420) comprend un multiplexeur de réinitialisation d'analyse (340 ; 440) comprenant :
un premier nœud d'entrée de multiplexeur de réinitialisation (341, 441) couplé au nœud d'entrée de réinitialisation d'analyse (322, 422),
un deuxième nœud d'entrée de multiplexeur de réinitialisation (342, 442) couplé à un signal de un logique (343, 443),
un nœud d'entrée de sélecteur de multiplexeur de réinitialisation (346, 446) couplé aux sorties de registres de données de test (134 ; 534 ; 634 ; 734), et
un nœud de sortie de multiplexeur de réinitialisation (344 ; 444) couplé au nœud de sortie de réinitialisation d'analyse correspondant (324, 424).

3. Circuit de commande de réinitialisation d'analyse (110 ; 210 ; 510 ; 610 ; 710 ; 810) selon la revendication 2, dans lequel chaque circuit de validation de réinitialisation de la pluralité de circuits de validation de réinitialisation (120 ; 320 ; 420) comprend en outre un multiplexeur de validation d'analyse (450) monté les sorties de registres de données de test (134 ; 534 ; 634 ; 734) et le nœud d'entrée de multiplexeur de sélecteur (446) du multiplexeur de réinitialisation d'analyse correspondant (440), le multiplexeur de validation d'analyse (450) comprenant :
une première entrée de multiplexeur de validation (451) couplée aux sorties de registres de données de test (134 ; 534 ; 634 ; 734),
un deuxième nœud d'entrée de multiplexeur de validation couplé à un signal de zéro logique (453),
un nœud d'entrée de sélecteur de multiplexeur de validation (456) couplé à un signal de validation d'analyse (417),
un nœud de sortie de multiplexeur de validation (454) couplé au nœud d'entrée de sélecteur de multiplexeur de réinitialisation (446) du multiplexeur de réinitialisation d'analyse correspondant (440).

4. Circuit de commande de réinitialisation d'analyse (110 ; 210 ; 510 ; 610 ; 710 ; 810) selon la revendication 1, comprenant en outre :
un seul nœud d'entrée de registre (533) couplé à un premier registre (531) de la pluralité de registres de données de test modifiables (530), les registres de données de test de la pluralité de registres de données de test modifiables (530) étant agencés en une chaîne de registres de données de test (535) configurée pour décaler dans la chaîne les valeurs de données reçues dans l'entrée de registre (533), dans lequel de préférence le circuit de commande de réinitialisation d'analyse comprend en outre une pluralité d'entrées de registre (633) couplée à la pluralité de registres de données de test modifiables (630) dans un rapport de un à un.

5. Circuit de commande de réinitialisation d'analyse (110 ; 210 ; 510 ; 610 ; 710 ; 810) selon la revendication 1, dans lequel le nombre total de nœuds de sortie de réinitialisation d'analyse (114 ; 214 ; 514 ; 614 ; 714) et le nombre total de sorties de registres (134 ; 534 ; 634 ; 734) de la pluralité de registres de données de test modifiables (130 ; 530 ; 630 ; 730) sont égaux.

6. Circuit de commande de réinitialisation d'analyse (110 ; 210 ; 510 ; 610 ; 710 ; 810) selon la revendication 1, comprenant en outre :
un décodeur (770) comprenant :
une pluralité de nœuds d'entrée de décodeur (772), chaque nœud d'entrée de décodeur de la pluralité de nœuds d'entrée de décodeur (772) étant couplé à une sortie de registre de données de test (134 ; 534 ; 634 ; 734) de la pluralité de registres de données de test modifiables (130 ; 530 ; 630 ; 730) dans un rapport de un à un, et
une pluralité de nœuds de sortie de décodeur (774), chaque nœud de sortie de décodeur de la pluralité de nœuds de sortie de décodeur (774) étant couplé à un nœud d'entrée correspondant d'un circuit de validation de réinitialisation respectif de la pluralité de circuits de validation de réinitialisation (120 ; 320 ; 420) dans un rapport de un à un,
dans lequel le nombre total de nœuds de sortie de réinitialisation de validation est supérieur au nombre total de sorties de registre de données de test (134 ; 534 ; 634 ; 734) de la pluralité de registres de données de test modifiables (130 ; 530 ; 630 ; 730).

7. Circuit intégré (200 ; 800) comprenant :
une pastille de réinitialisation d'analyse (211) configurée pour recevoir un signal de réinitialisation (external_scan_reset, 218) extérieur au circuit intégré (800) ;
une pluralité de blocs de circuit (260 ; 860) comprenant un ensemble de bascules d'analyse configurées pour être réinitialisées simultanément par le signal de réinitialisation (external_scan_reset, 218) ;
une pluralité de registres de données de test modifiables (130) comprenant des sorties de registres de données de test (134) configurées pour activer ou désactiver le signal de réinitialisation (external_scan_reset) ; et
une pluralité de circuits de validation de réinitialisation (120) couplée à la pluralité de blocs de circuit (260 ; 860) dans un rapport de un à un, chaque circuit de la pluralité de circuits de validation de réinitialisation (120) comprenant :
un nœud d'entrée (122) couplé à la pastille de réinitialisation d'analyse (211),
un nœud d'entrée de sélecteur (126) couplé aux sorties de registres de données de test (134), et
un nœud de sortie (124) couplé au bloc de circuit correspondant (260).

8. Circuit intégré (200 ; 800) selon la revendication 7,
dans lequel chaque circuit de la pluralité de circuits de validation de réinitialisation (120) comprend une pluralité de multiplexeurs de réinitialisation d'analyse (340, 440) comprenant chacun :
un premier nœud d'entrée de multiplexeur de réinitialisation couplé à la pastille de réinitialisation d'analyse (211),
un deuxième nœud d'entrée de multiplexeur de réinitialisation couplé à un signal de un logique,
un nœud d'entrée de sélecteur de multiplexeur de réinitialisation couplé aux sorties de registres de données de test, et
un nœud de sortie de multiplexeur de réinitialisation couplé au nœud de sortie de réinitialisation d'analyse correspondant.

9. Circuit intégré (200 ; 800) selon la revendication 8, comprenant en outre :
une pastille de validation d'analyse (215) configurée pour recevoir un signal de validation d'analyse (external_scan_enable) extérieur au circuit intégré (200 ; 800), le signal de validation d'analyse (external_scan_enable) étant configuré pour activer simultanément les sorties de registres de données de test ou désactiver le signal de réinitialisation,
dans lequel chaque circuit de la pluralité de circuits de validation de réinitialisation (120) comprend en outre une pluralité de multiplexeurs de validation d'analyse (450) montés entre les sorties de registres et l'entrée de sélecteur du multiplexeur de réinitialisation d'analyse correspondant (340, 440), chaque multiplexeur de la pluralité de multiplexeurs de validation d'analyse (450) comprenant :
un premier nœud d'entrée de multiplexeur de validation couplé aux sorties de registres de données de test,
un deuxième nœud d'entrée de multiplexeur de validation couplé à un signal de zéro logique,
un nœud d'entrée de sélecteur de multiplexeur de validation couplé à la pastille de validation d'analyse (215), et
un nœud de sortie de multiplexeur de validation couplé au nœud d'entrée de sélecteur de multiplexeur de réinitialisation du multiplexeur de réinitialisation d'analyse correspondant (450),
dans lequel de préférence le nombre total de sorties de réinitialisation d'analyse et le nombre total de sorties de registres de données de test de la pluralité de registres de données de test modifiables sont égaux.

10. Circuit intégré (200 ; 800) selon la revendication 7, comprenant en outre :
un décodeur (770) comprenant :
une pluralité de nœuds d'entrée de décodeur (772), chacun étant couplé à une sortie de registre de données de test correspondante (734) de la pluralité de registres de données de test modifiables (720) dans un rapport de un à un, et
une pluralité de nœuds de sortie de décodeur (774), chacun étant couplé à un nœud d'entrée correspondant (722) de circuits de validation de réinitialisation de la pluralité de circuits de validation de réinitialisation (720) dans un rapport de un à un,
dans lequel le nombre total de sorties de réinitialisation de validation (714) est supérieur au nombre total de sorties de registre de données de test (734) de la pluralité de registres de données de test modifiables (730).

11. Procédé (900) pour tester un circuit intégré (200 ; 800) selon l'une quelconque des revendications 7 à 10, le procédé comprenant les étapes suivantes :
décaler (907) une première séquence de test dans une pluralité d'ensembles de bascules d'analyse du circuit intégré (200 ; 800), chaque ensemble de bascules d'analyse étant compris dans un bloc de circuit correspondant de la pluralité de blocs de circuit (260 ; 860) du circuit intégré (200 ; 800) dans un rapport de un à un ;
stocker (901) une première séquence de réinitialisation dans une pluralité de registres de données de test modifiables (130) du circuit intégré (200 ; 800) ;
activer (902) un signal de réinitialisation d'analyse au niveau d'une pastille de réinitialisation d'analyse du circuit intégré (200 ; 800) pour chercher des défauts de réinitialisation ;
désactiver (903) le signal de réinitialisation d'analyse vers un premier sous-ensemble de blocs de circuit de la pluralité de blocs de circuit (260 ; 860) du circuit intégré (200 ; 800) et activer (904) le signal de réinitialisation d'analyse vers les blocs de circuit restants ne se trouvant pas dans le premier sous-ensemble au niveau des sorties des registres de données de test modifiables (130) en utilisant la première séquence de réinitialisation ;
lancer (905) la première séquence de test pendant que le signal de réinitialisation d'analyse est désactivé vers le premier sous-ensemble de blocs de circuit et activé vers les blocs de circuit restants ne se trouvant pas dans le premier sous-ensemble ; et
capturer (906) les résultats de la première séquence de test.

12. Procédé selon la revendication 11, comprenant en outre les étapes suivantes :
stocker une deuxième séquence de réinitialisation dans la pluralité de registres de données de test modifiables (130) ;
désactiver le signal de réinitialisation d'analyse vers un deuxième sous-ensemble de blocs de circuit de la pluralité de blocs de circuit et activer le signal de réinitialisation d'analyse vers les blocs de circuit restants ne se trouvant pas dans le deuxième sous-ensemble au niveau des sorties des registres de données de test modifiables (130) en utilisant la deuxième séquence de réinitialisation ;
lancer une deuxième séquence de test pendant que le signal de réinitialisation d'analyse est désactivé vers le deuxième sous-ensemble de blocs de circuit et activé vers les blocs de circuit restants ne se trouvant pas dans le deuxième sous-ensemble ; et
capturer les résultats de la deuxième séquence de test,
dans lequel de préférence la deuxième séquence de test est la même que la première séquence de test.

13. Procédé selon la revendication 11, comprenant en outre les étapes suivantes :
stocker une troisième séquence de réinitialisation dans la pluralité de registres de données de test de non analyse modifiables ;
désactiver le signal de réinitialisation d'analyse vers un troisième sous-ensemble de blocs de circuit de la pluralité de blocs de circuit et activer le signal de réinitialisation d'analyse vers les blocs de circuit restants ne se trouvant pas dans le troisième sous-ensemble au niveau des sorties des registres de données de test de non analyse modifiables en utilisant la troisième séquence de réinitialisation, le premier sous-ensemble et le deuxième sous-ensemble ayant au moins un bloc de circuit commun ;
lancer une troisième séquence de test pendant que le signal de réinitialisation d'analyse est désactivé vers le troisième sous-ensemble de blocs de circuit et activé vers les blocs de circuit restants ne se trouvant pas dans le troisième sous-ensemble ; et
capturer les résultats de la troisième séquence de test.

14. Procédé selon la revendication 13, dans lequel :
le procédé comprend en outre le fait de décaler la deuxième séquence de test dans la pluralité de sous-ensembles de bascules d'analyse avant de lancer la deuxième séquence de test, la deuxième séquence de test étant différente de la première séquence de test, et/ou
le premier sous-ensemble de blocs de circuit est choisi pour limiter la chute de tension ohmique sous un seuil prédéterminé dans le circuit intégré (200 ; 800) pendant le lancement (905) de la première séquence de test d'après une analyse de la chute de tension ohmique.

15. Procédé selon la revendication 11, dans lequel :
- le premier sous-ensemble de blocs de circuit est choisi de telle manière que les blocs de circuit restants ne se trouvant pas dans le premier sous-ensemble sont séparés physiquement les uns des autres, et/ou
- le premier sous-ensemble de blocs de circuit est choisi pour limiter le nombre de bascules dans les blocs de circuit restants ne se trouvant pas dans le premier sous-ensemble à une valeur prédéterminée pour atténuer la chute de tension ohmique dans le circuit intégré (200 ; 800) pendant le lancement (905) de la première séquence de test.
